# EUROPEAN PATENT APPLICATION

(11) **EP 4 060 714 A1**
(43) Date of publication of application: **21.09.2022**
(21) Application number: 21163522.2
(22) Date of filing: 18.03.2021
(51) Int. Cl.: H01J 37/02, H01J 37/10, H01J 37/28

(54) **FLOOD COLUMN AND CHARGED PARTICLEAPPARATUS**

(71) Applicant: ASML Netherlands B.V., 5500 AH Veldhoven (NL)
(72) Inventor: OTTEN, Christiaan, 5500 AH Veldhoven (NL); TEUNISSEN, Christan, 5500 AH Veldhoven (NL); SCHEEPERS, Paul, Hendricus, 5500 AH Veldhoven (NL); MEIJER, Joseph, Reinier, 5500 AH Veldhoven (NL)
(74) Representative: ASML Netherlands B.V.

(57) **Abstract**

Disclosed herein is a flood column for projecting a charged particle flooding beam along a beam path towards a sample to flood the sample with charged particles prior to assessment of the flooded sample using an assessment column, the flood column comprising: an anchor body (503) arranged along the beam path; a lens arrangement (504, 505) arranged in a down-beam part of the flood column; and a lens support (502, 507) arranged between the anchor body and the lens arrangement; wherein the lens support is configured to position the lens arrangement and the anchor body relative to each other; the lens support comprises an electrical insulator; and the lens support is in the direct line of sight of at least a portion of the beam path in the down-beam part.

## Description

### FIELD

The present invention relates to a flood column comprising a down-beam lens arrangement, as well as a charged particle apparatus comprising the flood column.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an import process during and/or after its manufacture.

Pattern inspection tools with a charged particle beam have been used to inspect objects, for example to detect pattern defects. (Note: the term tool, such as inspection, measurement or assessment tool, is intended to be interpreted as an apparatus, system or device). These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

Dedicated flood columns may be used in conjunction with an SEM to flood a large area of the surface of a substrate or other sample with charged particles for example in a beam (i.e. as a current) towards the sample, in a relatively short time. Flood columns are thus useful tools to pre-charge a wafer surface and set the charging conditions for subsequent inspection with an SEM. A dedicated flood column can enhance the voltage contrast defect signal, thereby increasing the defect detection sensitivity and/or throughput of an SEM. During charged particle flooding, the flood column is used to provide a relatively large amount of charged particles to quickly charge a predefined area. Afterwards, the primary electron source of an e-beam inspection system is applied to scan an area within the pre-charged area to achieve imaging of the area.

### SUMMARY

Embodiments of the invention are directed towards the relative positioning of an aperture body and a lens arrangement that is down-beam of the aperture body. The aperture body and lens arrangement of embodiments may be for use in a flood column.

According to a first aspect of the present invention, there is provided a flood column for projecting a charged particle flooding beam along a beam path towards a sample to flood the sample with charged particles prior to assessment of the flooded sample using an assessment column, the flood column comprising: an anchor body arranged along the beam path; a lens arrangement arranged in a down beam part of the flood column; and a lens support arranged between the anchor body and the lens arrangement; wherein the lens support is configured to position the lens arrangement and the anchor body relative to each other; the lens support comprises an electrical insulator; and the lens support is in the direct line of sight of at least a portion of the beam path in the down beam part.

According to a second aspect of the present invention, there is provided a flood column for projecting a charged particle flooding beam along a beam path towards a sample to flood the sample with charged particles prior to assessment of the flooded sample using an assessment column, the flood column comprising: an anchor body around along the beam path an electro-magnetic shield configured to shield at least part of the beam path; a lens arrangement arranged in the beam path down-beam of the anchor body; and a lens support arranged between the anchor body and the lens arrangement and configured to support the position of the lens arrangement relative to the anchor body; wherein the lens support comprises an electrical insulator; and the shield comprises a down-beam end, that is positioned between the anchor body and at least part of the lens arrangement, and the shield is configured to extend along the beam path up to the down-beam end.

According to a third aspect of the present invention, there is provided a charged particle assessment tool comprising: a stage configured to support a sample; a charged particle system for assessing the sample, wherein the charged particle system is configured to project a charged particle beam towards the sample and to detect charged particles emanating from the sample; and the flood column according to any proceeding claim configured to project a charged particle flooding beam towards the sample so as to flood the sample.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings, in which:
**FIG. 1** schematically depicts a charged particle beam inspection apparatus;
**FIG. 2** schematically depicts a charged particle tool, which may form part of the charged particle beam inspection apparatus of **FIG. 1****;**
**FIG. 3A** schematically depicts a flood column operated in a high-density mode;
**FIG. 3B** schematically depicts a flood column operated in a low-density mode;
**FIG. 4** schematically depicts components of a flood column according to an embodiment;
**FIG. 5A** schematically depicts some of the components of the flood column that are down-beam of the aperture body according to an embodiment;
**FIG. 5B** schematically depicts some of the components of the flood column that are down-beam of the aperture body according to an embodiment;
**FIG. 6A** schematically depicts a cross-section through a component of the flood column, that is down-beam of the aperture body, according to an embodiment;
**FIG. 6B** schematically depicts a cross-section through a component of the flood column, that is down-beam of the aperture body, according to an embodiment; and
**FIG. 6C** schematically depicts a cross-section through a component of the flood column, that is down-beam of the aperture body, according to an embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If an individual step has a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination system that comprises an electron source, for generating primary electrons, and a projection system for scanning a sample, such as a substrate, with one or more focused beams of primary electrons. The primary electrons interact with the sample and generate secondary electrons. A detection system captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

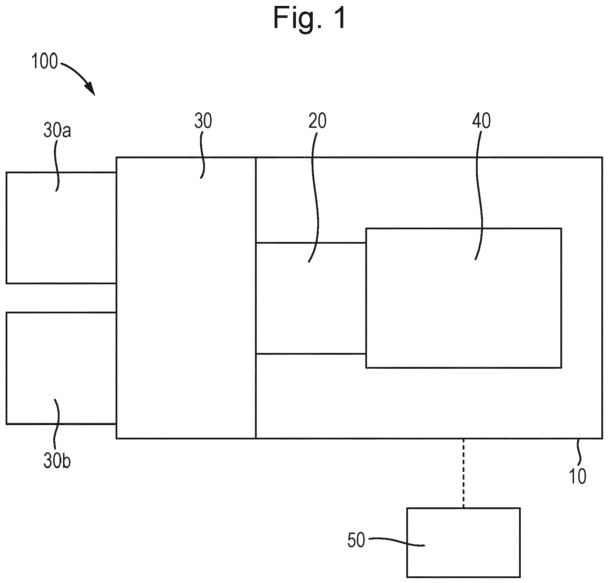

Reference is now made to Fig. 1, which is a schematic diagram illustrating a charged particle beam inspection apparatus 100. The charged particle beam inspection apparatus 100 of Fig. 1 includes a main chamber 10, a load lock chamber 20, a charged particle tool 40, an equipment front end module (EFEM) 30 and a controller 50. Charged particle tool 40 is located within main chamber 10. Charged particle tool 40 may be an electron beam tool 40. Charged particle tool 40 may be a single-beam tool or a multi-beam tool.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be subject to charged particle flooding and/or inspection.

Controller 50 is electronically connected to charged particle beam tool 40. Controller 50 may be a processor (such as a computer) configured to control the charged particle beam inspection apparatus 100. Controller 50 may also include a processing circuitry configured to execute various signal and image processing functions. While controller 50 is shown in Fig. 1 as being outside of the structure that includes main chamber 10, load lock chamber 20, and EFEM 30, it is appreciated that controller 50 may be part of the structure. The controller 50 may be located in one of the component elements of the charged particle beam inspection apparatus 100 or it can be distributed over at least two of the component elements.

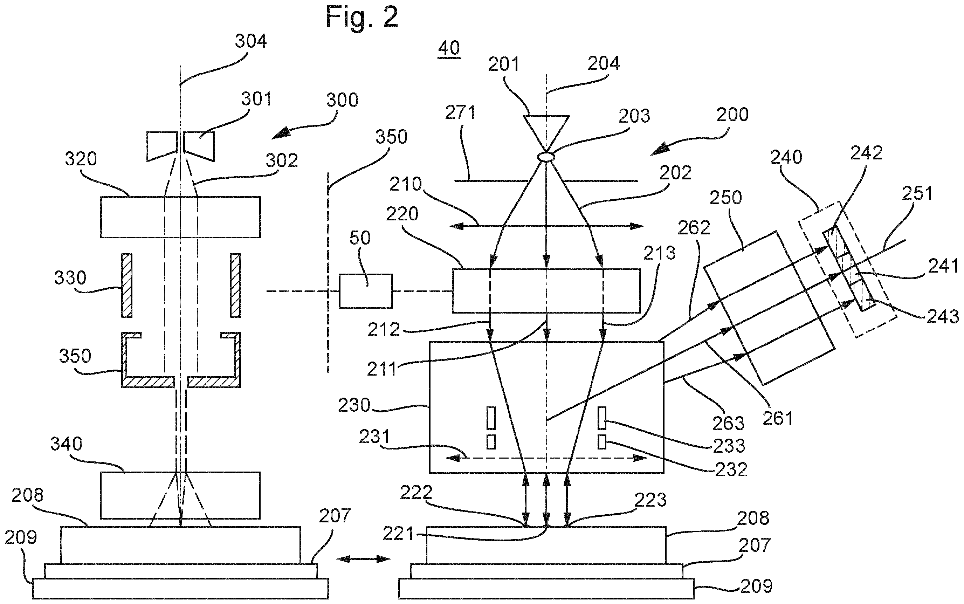

Reference is now made to **FIG. 2****,** which is a schematic diagram illustrating an exemplary charged particle tool 40. The charged particle tool 40 may form part of the charged particle beam inspection apparatus 100 of Fig. 1. The charged particle tool 40 may comprise a charged particle inspection tool 200. As shown in Fig. 1, the charged particle inspection tool 200 may be a multi-beam inspection tool 200. Alternatively, the charged particle inspection tool 200 may be a single-beam inspection tool. The charged particle inspection tool 200 comprises an electron source 201, a gun aperture plate 271, a condenser lens 210, optionally a source conversion unit 220, a primary projection system 230, a motorized stage 209, and a sample holder 207. The electron source 201, the gun aperture plate 271, the condenser lens 210, and optionally the source conversion unit 220 are the components of an illumination system comprised by the charged particle inspection tool 200. The sample holder 207 is supported by motorized stage 209 so as to hold and optionally to position a sample 208 (e.g., a substrate or a mask), for example for inspection or for charged particle flooding. The charged particle inspection tool 200 may further comprise a secondary projection system 250 and an associated electron detection device 240 (which together may form a detection column or detection system). Electron detection device 240 may comprise a plurality of detection elements 241, 242, and 243. Primary projection system 230 may comprise an objective lens 231 and optionally the source conversion unit 220 (if it is not part of the illumination system). Together the primary projection system and the illumination system may be referred to as a primary column or primary electron-optical system. A beam separator 233 and a deflection scanning unit 232 may be positioned inside primary projection system 230.

The components for example of the primary column, that are used to generate a primary beam may be aligned with a primary electron-optical axis of the charged particle inspection tool 200. These components can include: the electron source 201, gun aperture plate 271, condenser lens 210, source conversion unit 220, beam separator 233, deflection scanning unit 232, and primary projection apparatus 230. The components of the primary column, or indeed the primary column, generate a primary beam, which may be a multibeam, towards a sample for inspection of the sample. Secondary projection system 250 and its associated electron detection device 240 may be aligned with a secondary electron-optical axis 251 of the charged particle inspection tool 200.

The primary electron-optical axis 204 is comprised by the electron-optical axis of the part of the charged particle inspection tool 200 that is the illumination system. The secondary electron-optical axis 251 is the electron-optical axis of the part of the charged particle inspection tool 200 that is a detection system (or detection column). The primary electron-optical axis 204 may also be referred to herein as the primary optical axis (to aid ease of reference) or charged particle optical axis. The secondary electron-optical axis 251 may also be referred to herein as the secondary optical axis or the secondary charged particle optical axis.

Electron source 201 may comprise a cathode (not shown) and an extractor or anode (not shown). During operation, electron source 201 is configured to emit electrons as primary electrons from the cathode. The primary electrons are extracted and accelerated by the extractor and/or the anode to form a primary electron beam 202 that forms a primary beam crossover (virtual or real) 203. Primary electron beam 202 may be visualized as being emitted from primary beam crossover 203. In an arrangement the electron source 201 may operate at a high voltage and/or high energy, for example more than 20 keV preferably more than 30 keV, 40keV or 50keV. The electrons from the electron source have a high landing energy for example relative to a sample 208 for example on the sample holder 207.

In this arrangement a primary electron beam, by the time it reaches the sample, and preferably before it reaches the projection system, is a multi-beam. Such a multi-beam can be generated from the primary electron beam in a number of different ways. For example, the multi-beam may be generated by a multi-beam array located before the cross-over, a multi-beam array located in the source conversion unit 220, or a multi-beam array located at any point in between these locations. A multi-beam array may comprise a plurality of electron beam manipulating elements arranged in an array across the beam path. Each manipulating element may influence the primary electron beam to generate a sub-beam. Thus the multi-beam array interacts with an incident primary beam path to generate a multi-beam path down-beam of the multi-beam array.

Gun aperture plate 271, in operation, is configured to block off peripheral electrons of primary electron beam 202 to reduce Coulomb effect. The Coulomb effect may enlarge the size of each of probe spots 221, 222, and 223 of primary sub-beams 211, 212, 213, and therefore deteriorate inspection resolution. A gun aperture plate 271 may also be referred to as a Coulomb aperture array.

Condenser lens 210 is configured to focus primary electron beam 202. Condenser lens 210 may be designed to focus primary electron beam 202 to become a parallel beam and be normally incident onto source conversion unit 220. Condenser lens 210 may be a movable condenser lens that may be configured so that the position of its first principle plane is movable. The movable condenser lens may be configured to be magnetic. Condenser lens 210 may be an anti-rotation condenser lens and/or it may be movable. The condenser lens 210 may comprise a plurality of static lenses that may be operated so that the position of its lens principle plane is moveable.

Source conversion unit 220 may comprise an image-forming element array, an aberration compensator array, a beam-limit aperture array, and a pre-bending micro-deflector array. The pre-bending micro-deflector array may deflect a plurality of primary sub-beams 211, 212, 213 of primary electron beam 202 to normally enter the beam-limit aperture array, the image-forming element array, and an aberration compensator array. In this arrangement, the image-forming element array may function as a multi-beam array to generate the plurality of sub-beams in the multi-beam path, i.e. primary sub-beams 211, 212, 213. The image forming array may comprise a plurality electron beam manipulators such as micro-deflectors micro-lenses (or a combination of both) to influence the plurality of primary sub-beams 211, 212, 213 of primary electron beam 202 and to form a plurality of parallel images (virtual or real) of primary beam crossover 203, one for each of the primary sub-beams 211, 212, and 213. The aberration compensator array may comprise a field curvature compensator array (not shown) and an astigmatism compensator array (not shown). The field curvature compensator array may comprise a plurality of micro-lenses to compensate field curvature aberrations of the primary sub-beams 211, 212, and 213. The astigmatism compensator array may comprise a plurality of micro-stigmators, or multi-pole electrodes, to compensate astigmatism aberrations of the primary sub-beams 211, 212, and 213. The beam-limit aperture array may be configured to limit diameters of individual primary sub-beams 211, 212, and 213. **FIG. 2** shows three primary sub-beams 211, 212, and 213 as an example, and it should be understood that source conversion unit 220 may be configured to form any number of primary sub-beams. Controller 50 may be connected to various parts of charged particle beam inspection apparatus 100 of **FIG. 1****,** such as source conversion unit 220, electron detection device 240, primary projection system 230, or motorized stage 209. As explained in further detail below, controller 50 may perform various image and signal processing functions. Controller 50 may also generate various control signals to govern operations of the charged particle beam inspection apparatus, including the charged particle multi-beam apparatus.

Condenser lens 210 may further be configured to adjust electric currents of primary sub-beams 211, 212, 213 down-beam of source conversion unit 220 by varying the focusing power of condenser lens 210. Alternatively, or additionally, the electric currents of the primary sub-beams 211, 212, 213 may be changed by altering the radial sizes of beam-limit apertures within the beam-limit aperture array corresponding to the individual primary sub-beams. The electric currents may be changed by both altering the radial sizes of beam-limit apertures and the focusing power of condenser lens 210. If the condenser lens is moveable and magnetic, off-axis sub-beams 212 and 213 may result that illuminate source conversion unit 220 with rotation angles. The rotation angles change with the focusing power or the position of the first principal plane of the movable condenser lens. A condenser lens 210 that is an anti-rotation condenser lens may be configured to keep the rotation angles unchanged while the focusing power of condenser lens 210 is changed. Such a condenser lens 210 that is also movable, may cause the rotation angles not change when the focusing power of the condenser lens 210 and the position of its first principal plane are varied.

Objective lens 231 may be configured to focus sub-beams 211, 212, and 213 onto a sample 208 for inspection and may form three probe spots 221, 222, and 223 on the surface of sample 208.

Beam separator 233 may be, for example, a Wien filter comprising an electrostatic deflector generating an electrostatic dipole field and a magnetic dipole field (not shown in **FIG. 2**). In operation, beam separator 233 may be configured to exert an electrostatic force by electrostatic dipole field on individual electrons of primary sub-beams 211, 212, and 213. The electrostatic force is equal in magnitude but opposite in direction to the magnetic force exerted by magnetic dipole field of beam separator 233 on the individual electrons. Primary sub-beams 211, 212, and 213 may therefore pass at least substantially straight through beam separator 233 with at least substantially zero deflection angles.

Deflection scanning unit 232, in operation, is configured to deflect primary sub-beams 211, 212, and 213 to scan probe spots 221, 222, and 223 across individual scanning areas in a section of the surface of sample 208. In response to incidence of primary sub-beams 211, 212, and 213 or probe spots 221, 222, and 223 on sample 208, electrons are generated from the sample 208 which include secondary electrons and backscattered electrons. The secondary electrons propagate in three secondary electron beams 261, 262, and 263. The secondary electron beams 261, 262, and 263 typically have secondary electrons (having electron energy ≤ 50eV) and may also have at least some of the backscattered electrons (having electron energy between 50eV and the landing energy of primary sub-beams 211, 212, and 213). The beam separator 233 is arranged to deflect the path of the secondary electron beams 261, 262, and 263 towards the secondary projection system 250. The secondary projection system 250 subsequently focuses the path of secondary electron beams 261, 262, and 263 onto a plurality of detection regions 241, 242, and 243 of electron detection device 240. The detection regions may be the separate detection elements 241, 242, and 243 that are arranged to detect corresponding secondary electron beams 261, 262, and 263. The detection regions generate corresponding signals which are sent to controller 50 or a signal processing system (not shown), e.g. to construct images of the corresponding scanned areas of sample 208.

The detection elements 241, 242, and 243 may detect the corresponding secondary electron beams 261, 262, and 263. On incidence of secondary electron beams with the detection elements 241, 242 and 243, the elements may generate corresponding intensity signal outputs (not shown). The outputs may be directed to an image processing system (e.g., controller 50). Each detection element 241, 242, and 243 may comprise one or more pixels. The intensity signal output of a detection element may be a sum of signals generated by all the pixels within the detection element.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

Although **FIG. 2** shows that the charged particle inspection tool 200 uses three primary electron sub-beams, it is appreciated that the charged particle inspection tool 200 may use two or a greater number of primary electron sub-beams. The present disclosure does not limit the number of primary electron beams used in the charged particle inspection tool 200. The charged particle inspection tool 200 may also be a single-beam inspection tool 200, which uses a single charged particle beam.

As shown in Fig. 2, the charged particle beam tool 40 may further comprise a flood column 300, or flood gun. The flood column 300 may be used to pre-charge the surface of the sample 208 and set the charging conditions. For example the flood column may pre-charge the surface of the sample 208 prior to inspection by the charged particle inspection apparatus 200. This may enhance the voltage contrast defect signal, so as to increase the defect detection sensitivity and/or throughput of the charged particle inspection apparatus 200. The flood column 300 may be used to provide a relatively large amount of charged particles to charge a predefined area. Afterwards, the charged particle inspection apparatus 200 may scan the pre-charged area of the sample 208 to achieve imaging of the area. The motorized stage 209 may move the sample 208 from a position for charged particle flooding by the flood column 300 to a position for inspection by the charged particle inspection apparatus 200. Put another way, the motorized stage 209 may be used to move the sample 208 into the position for charged particle flooding. The flood column 300 may then flood the sample 208 with charged particles. The motorized stage 209 may then be used to move the sample 208 into the position for inspection; then the charged particle inspection apparatus 200 may be used to inspect the sample 208. Alternatively, the position for charged particle flooding by the flood column 300 may coincide with the position for inspection by the charged particle inspection apparatus 200, such that the sample 208 and the motorized stage 209 remain substantially in place after charged particle flooding and before inspection.

The flood column 300 may comprise at least a charged particle source 301 which may be in a generator system, a condenser lens 320, a blanker electrode 330, an objective lens 340 and an aperture body 350. The flood column 300 may also comprise additional components for manipulation of the charged particle beam 302 such as a scanning element (not shown) and a field lens (not shown). The components of the flood column 300 may be arranged substantially along an axis 304. The axis 304 may be the electro-optical axis of the flood column 300. The components of the flood column 300 may be controlled by the controller 50. Alternatively, a dedicated controller may be used to control the components of the flood column 300, or the components of the flood column 300 may be controlled by multiple respective controllers. The flood column 300 may be mechanically coupled to the charged particle inspection apparatus 200. That is the flood column is connected, even coupled, to the primary column of the charged particle inspection apparatus 200. Preferably the flood column is connected to the primary column at an interface 350 between the flood column 300 and the primary column.

The charged particle source 301 may be an electron source. The charged particle source 301 may comprise a charged particle emitting electrode (e.g. a cathode) and an accelerating electrode (e.g. an anode). The charged particles are extracted and accelerated from the charged particle emitting electrode by the accelerating electrode to form a charged particle beam 302. The charged particle beam 302 may propagate along a beam path 302. The beam path 302 may comprise the axis 304, for example in situations in which the charged particle beam 302 is not deflected away from the axis 304. In an arrangement the electron source 301 operates at a high voltage, for example more than 20 keV preferably more than 30 keV, 40keV or 50keV. The electrons from the electron source 301 may have a high landing energy for example relative to a sample 208 for example on the sample holder 207. However, embodiments also include implementations in which the electrons do not have a high landing energy. For example, the electrons emitted from the source may be accelerated to a high beam energy of 30keV. The electrons may then be decelerated to an energy in the range 0.3keV to 3keV before hitting the sample 208. Preferably the electron source 301 of the flood column operates at the same, or at least substantially the same operating voltage as the electron source 201 of primary column. Electrons from the electron source 301 of the flood column 300 desirably have the same, or at least a substantially similar landing energy to electrons emitted by the electron source 201 of the inspection tool 200.

Having the sources 201, 301 of both flood column and the primary column at substantially the same operating voltage is desirable. This is because the sample 208, and thus preferably the substrate support and desirably the moveable stage 209 are set at the same operating voltage for inspection and/or measurement and flooding. That is they may be biased to the source of the primary column during inspection and the source of the flood column during flooding. The relative potential between the primary source and the stage is high. Flood columns, such as those that are commercially available, have an operating voltage substantially less than the high voltage of the inspection tool 200. Such a stage cannot be maintained at high voltage during flooding, since the stages are biased relative to an operating source, whether of the flood column or the primary column. The biasing of the stage should therefore change to suit the source next to operate. For a commercially available flood column, the source can be set to a potential to near ground potential.

The stage may be moved between a flooding position and an inspection/measurement position (e.g. assessment position). It takes time to move the moveable stage 209 between a flooding position when the sample is in the beam path of the flood column, and an inspection position when the sample is in the beam path of the primary column. Yet the time taken to adjust the stage potential between inspection and flooding settings for a typical commercial flood column and high voltage inspection tool, may take longer than the movement between the flooding and inspection positions. The change in voltage can take as long as minutes. Therefore, there is a significant throughput improvement in having a flood column having at least a similar operating voltage to the primary column; this is even for an inspection or measurement tool with a separate flood column having its own flooding position apart from an inspection position. Another or alternative benefit is that in reducing the time between flooding and inspection and/or measurement, the flooding effect remains and the risk of it disappearing before inspection/measurement is reduced if not prevented.

The condenser lens 320 is positioned down-beam of the charged particle source 301, i.e. the condenser lens 320 is positioned in a down-beam direction relative to the charged particle source 301. The condenser lens 320 may focus or defocus the charged particle beam 302. As shown in Fig. 2, the condenser lens 320 may be used to collimate the charged particle beam 302. However, the condenser lens 320 may also be used to control the charged particle beam 302 so as to create a divergent beam or a convergent beam.

The aperture body 350 may be positioned down-beam of the condenser lens 320. The aperture body 350 may pass a portion, or only a portion and not all, of a charged particle beam propagating along an axis 304. The aperture body 350 may limit the lateral extent of the charged particle beam 302, as depicted in Fig. 2. The aperture body 350 may also be used to selectively blank the charged particle beam 302, so as to prevent passage of any portion of the charged particle beam 302. The aperture body 350 may define an opening. If the lateral extent (or diameter) of the charged particle beam 302 is larger than the lateral extent (or diameter) of the opening, then only a portion of the charged particle beam 302 will pass through the opening. The aperture body 350 may thus limit the lateral extent of the charged particle beam 302, so as to act as a beam-limiting aperture. The cross section of the beam that is down-beam of the aperture body 350 may be geometrically similar (in case of a divergent or convergent beam) or geometrically identical (in case of a collimated beam) to the cross-section of the opening in the aperture body 350. The opening may be substantially circular. The opening may have a lateral extent (or diameter) in the range from 100µm to 10mm, preferably from 200µm to 5mm, further preferably from 500µm to 2mm

The blanking electrode 330 may be positioned down-beam of the condenser lens 320 and up-beam of the aperture body 350. The blanking electrode 330 may selectively deflect the charged particle beam 302, for example deflect the charged particle beam 302 away from the axis 304. The blanking electrode 330 may deflect the charged particle beam 302 away from the opening in the aperture body 350, for example onto a portion of the aperture body 350 that does not comprise the opening, so as to prevent any portion of the charged particle beam 302 from passing through the opening defined by the aperture body 350. The blanking electrode 330 may blank the beam so that beam does not pass through the opening of the aperture body 350. However, the combination of the blanking electrode 330 and the aperture body 350 may also be used to selectively blank the charged particle beam 302, i.e. to selectively prevent passage of at least part the charged particle beam 302 through the opening in the aperture body 350. That is, the combination of the blanking electrode 330 and the aperture body 350 may selectively control the proportion of the charged particle beam 302 that passes the opening.

The objective lens 340 is positioned down-beam of the aperture body 350. The objective lens 340 may focus or defocus the charged particle beam 302. As shown in Fig. 2, the objective lens 320 may be used to control the charged particle beam 302 so as to create a divergent beam, thereby increasing the spot size on the sample 208 and increasing the area of the surface on the sample 208 that is flooded with charged particles. However, in some situations, the objective lens 340 may be used to control the charged particle 302 so as to create a convergent beam, thereby focusing the charged particle beam 302 onto the sample 208. A field lens 370, for example positioned down-beam of the objective lens, may be used to set the strength of the electric field between the field lens and the sample 208. This electric field affects the charged particle as they travel towards the sample 208, thereby affecting the charging speed and the charging level (i.e. the maximum voltage of the sample 208 with respect to electrical ground after charged particle flooding) of the sample 208 during charged particle flooding.

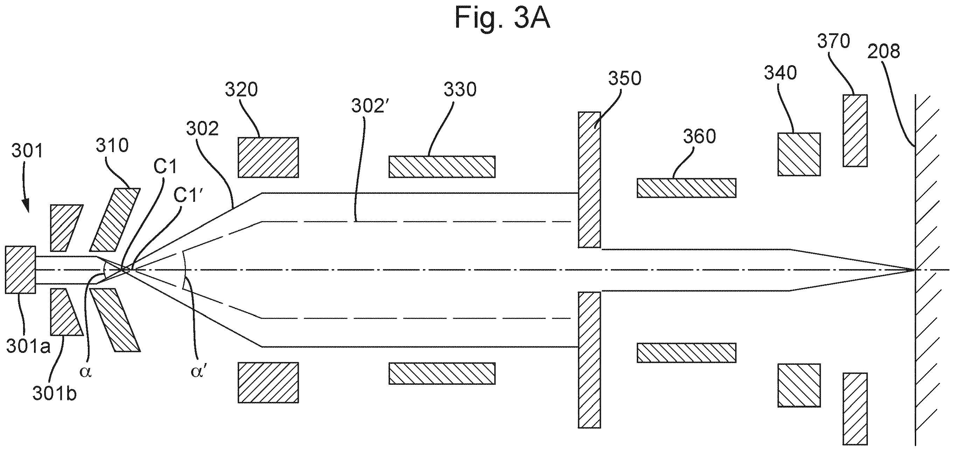

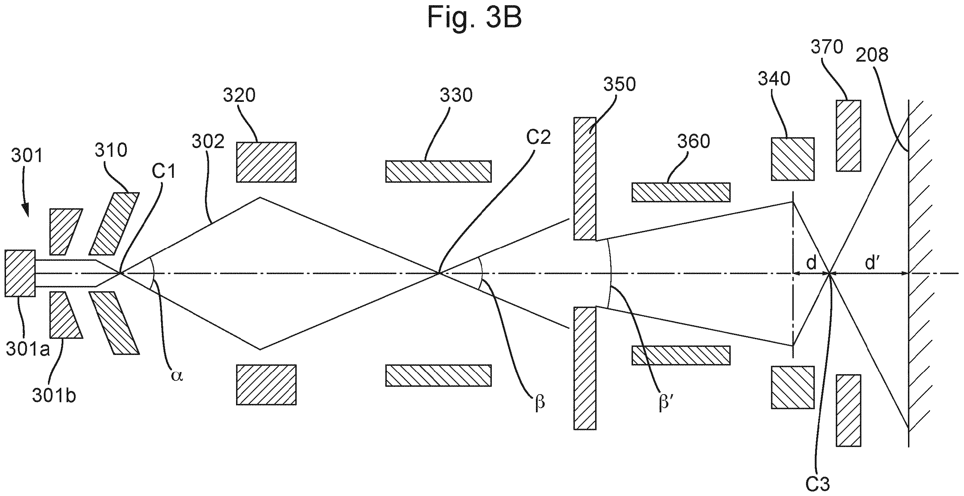

The flood column 300 may selectively be operated in different modes of operation, such as in a high-density mode (as schematically depicted in Fig. 3A) and in a low-density mode (as schematically depicted in Fig. 3B). The flood column 300 of Figs. 3A and 3B may comprise the charged particle source 301, the condenser lens 320, the blanking electrode 330, the aperture body 350, the objective lens 340, scanning electrodes 360 and the field lens 370. The charged particle source 301 comprises the charged particle emitting electrode 301a (e.g. the cathode) and the accelerating electrode 301b (e.g. the anode). The flood column may additionally comprise a source lens 310. The flood column 300 may switch between the high-density mode and the low-density mode of operation. Alternatively, the flood column 300 may be operated in only one mode of operation, such as in either one of the high-density mode and the low-density mode. The controller 50 may control the mode of operation of the flood column 300, so as to selectively operate the flood column 300 in the high-density mode and in the low-density mode. A user may instruct the flood column 300, or the controller 50, to selectively operate in one of the modes of operation. Alternatively, the controller 50 may automatically control the mode of operation of the flood column 300, for example based on a pre-set program or order of operations.

The high-density mode is for charged particle flooding of a relatively small area of the sample 208. In the high-density mode, the lateral extent (or diameter) of the charged particle beam 302 incident at the sample 208, also referred to as the lateral extent (or diameter) of the beam spot herein, is relatively small. The lateral extent (or diameter) of the beam spot in the high-density mode is relatively small, in particular compared to the lateral extent (or diameter) of the beam spot in the low-density mode. As such, the charge density of the beam spot in the high-density mode is relatively high, in particular compared to the charge density of the beam spot in the low-density mode. In the high-density mode, the lateral extent (or diameter) of the beam spot may be in the range from 0 to 1000µm, preferably between 5µm and 500µm. However, the spot size is dependent on the application. The typical application requirements are in the range of 25µm to 500µm, which is the preferred operational range. The beam spot can then be selected from the operation range during operation dependent on the application. An upper limit of the operation range is selected because above 500µm the required current density is difficult to achieve. With available optics a lower limit to the range can be higher than 5µm, for example 10µm, 25µm or 50µm.

The low-density mode is for charged particle flooding of a relatively large area of the sample 208. In the low-density mode, the lateral extent (or diameter) of the beam spot is relatively large, in particular compared to the lateral extent (or diameter) of the beam spot in the high-density mode. As such, the charge density of the beam spot in the low-density mode is relatively low, in particular compared to the charge density of the beam spot in the high-density mode. In the low-density mode, the lateral extent (or diameter) of the beam spot may be greater than 500µm, preferably greater than 1mm, further preferably greater than 3mm, particularly preferably greater than 5mm, for example about 8mm. The lateral extent (or diameter) of the beam spot in the low-density mode may be in the range from 500µm to 50mm, preferably from 1mm to 20mm, further preferably from 3mm to 15mm, particularly preferably from 5mm to 12mm.

As shown in Figs. 3A and 3B, the flood column 300 may comprise the source lens 310. The source lens 310 is arranged or located down-beam, for example directly down-beam, of the charged particle source 301, in particular down-beam of the accelerating electrode (e.g. the anode) of the charged particle source 301. The source lens 310 is arranged or located up-beam of the condenser lens 320, for example directly up-beam of the condenser lens 320. The source lens 310 may manipulate the charged particle beam 302, in particular by adjusting the focus or the beam angle α of the charged particle beam 302 down-beam of the source lens 310 and up-beam of the condenser lens 320. (Note that all references to beam angles in this specification are the maximum angular displacement across the beam cross-section. An alternative definition of beam angle could be the maximum angular displacement of the beam relative to the electron-optical axis, shown in dotted lines in Figs 3A and 3B. The alternative definition of beam angle, relative to the axis, would be half of that beam angle provided herein). The source lens 310 preferably manipulates the charged particle beam 302 so as to create a divergent charged particle beam 302 up-beam of the condenser lens 320. As shown in Figs. 3A and 3B, the source lens 310 may focus the charged particle beam to a cross-over point C1 that is located up-beam of the condenser lens 320, thereby creating a divergent charged particle beam 302 up-beam of the condenser lens 320 (and down-beam of the cross-over point C1). In some arrangements, this may allow a larger beam divergence (i.e. a larger beam angle α) compared to defocusing the charged particle beam 320. Alternatively, the source lens 310 may defocus the charged particle beam 302, thereby creating a divergent charged particle beam 302 up-beam of the condenser lens 320 (not shown). By defocusing, the source lens diverges the beam path relative to a virtual cross-over point up-beam of the source lens 310. The beam angle α of the diverging beam is thus determined relative to the virtual cross-over point Reference in the following text to the beam angle α should be understood to refer to both implementations with a cross-over and a virtual cross-over up-beam of the source lens 310.

As shown in Fig. 3A, for example in the high-density mode, the source lens 310 may be controllable so as to variably set the beam angle α (or the amount of focus/defocus) of the charged particle beam 302, thus the extent of divergence of the charged particle beam 302, down-beam of the source lens 310 (for a virtual cross-over) or down-beam of the cross-over point C1. When the source lens 310 focusses the charged particle beam 302 onto the cross-over point C1, the source lens 310 may be controllable so as to variably set the position of the cross-over point C1 along the axis 304. The source lens 310 may thus be used to vary the beam angle α of the charged particle beam 302. The source lens 310 may be used to set the beam angle α to a plurality of (predetermined) values within a range. Alternatively, the source lens 310 may be used to vary the beam angle α within a predetermined continuous range. The source lens 310 may, for example, vary the beam angle α within the range at least from 0° to 5°, preferably at least from 0° to 10°. This may adjust the lateral extent of the charged particle beam 302 (e.g. of the collimated charged particle beam 302, 302' depicted in Fig. 3A) down-beam of the condenser lens 320 and up-beam of the aperture body 350. Adjust the lateral extent of the charged particle beam 302 may variably set the proportion of the charged particle beam 302 that passes through the aperture body 350. The source lens 310 may, for example, vary the proportion of the charged particle beam 302 that passes through the aperture body within a range at least from 100% to 50%, preferably at least from 100% to 25%, further preferably at least from 100% to 10%, particularly preferably at least from 100% to 5%.

For example, Fig. 3A shows that the source lens 310 may selectively set the beam angle to α or α', thereby respectively creating the cross-over points C1 and C1'. As depicted in Fig. 3A, this varies the lateral extent of the charged particle beam 302, 302' up-beam of the aperture body 350, and independently from the beam angle of the charged particle beam 302 up-beam of the aperture body 350 (which beam angle may be set by the condenser lens 320 - for example to zero degrees 0° relative to the electron-optical axis to create a collimated charged particle beam 302). Variably setting the beam angle α, α' using the source lens 310 thus effectively variably sets the proportion of the charged particle beam 302, 302' that passes through the aperture body 350. With reference to Fig. 3A, when the source lens 310 sets a relatively large beam angle α, the lateral extent of the charged particle beam 302 up-beam of the aperture 350 is relatively large, such that a relatively small proportion of the charged particle beam 302 passes the aperture body 350. Conversely, when the source lens 310 sets a relatively small beam angle α', the lateral extent of the charged particle beam 302' up-beam of the aperture 350 is relatively small, such that a relatively large proportion of the charged particle beam 302' passes the aperture body 350.

Alternatively or additionally, for example in the low-density mode, the source lens 310 may also be controllable so as to set, or fixedly set, the beam angle α (or the amount of focus/defocus) of the charged particle beam 302 down-beam of the source lens 310. This is shown, for example, in Figure 3B. When the source lens 310 focusses the charged particle beam 302 to the cross-over point C1, the source lens 310 may be controllable so as to set, or fixedly set, the position of the cross-over point C1 (which may be virtual and up-beam of the source lens 310) along the axis 304. This may fixedly set the proportion of the charged particle beam 302 that passes through the aperture body 350. The source lens 310 may, for example, set the beam angle α to the maximum beam angle used in the high-density mode. The source lens 310 may set the beam angle α so as to maximize the lateral extent of the charged particle beam at the condenser lens 320. This may create a maximally divergent beam down-beam of the aperture body 350, which ultimately may achieve the maximum spot size at the sample 208. For example, the source lens 310 may achieve a magnification of the charged particle beam 302 (from the source lens 310 to the condenser lens 320) in the range from 1 to 20, preferably from 2 to 15, further preferably from 5 to 10.

As shown in Fig. 3A, for example for the high density mode, the condenser lens 320 may be controllable so as to collimate, or substantially collimate, the charged particle beam 302. The condenser lens 320 may be controllable to set the beam angle of the charged particle beam 302 down-beam of the condenser lens 320 and up-beam of the aperture body 350 to 0°, or substantially 0°, for example to a value in the range from 0° to 5° relative to the direction of the axis 304. The condenser lens 320 may be controllable so as to fixedly set the beam angle of the charged particle beam 302 up-beam of the aperture body 350. The condenser lens 320 may thus counteract any effects that the source lens 310 may have on the beam angle of the charged particle beam 302 (just) up-beam of the aperture body 350.

Alternatively or additionally, as shown in Fig. 3B, for example in the low-density mode, the condenser lens 350 may be controllable so as to create a divergent charged particle beam 302 up-beam of the aperture body 305. The condenser lens 320 may be controllable, for example, so as to focus the charged particle beam 302 to a cross-over point C2 down-beam of the condenser lens 320 and up-beam of the aperture body 350, such that the charged particle beam 302 diverges up-beam of the aperture body and down-beam of the aperture body. This may increase the lateral extent of the charged particle beam 302 at the objective lens 340, compared to a situation in which the charged particle beam 302 down-beam of the aperture body 350 is collimated. See for example a comparison of Figs. 3B and 3A. The increased lateral extent of the charged particle beam 302 at the objective lens 340 allows the objective lens to further increase or maximise the beam spot at the sample 208. The objective lens 340 may focus the charged particle beam 302. The focussing effect of the objective lens 340 on charged particles in the charged particle beam is greater on charged particles that are displaced further from the axis 304 (and thereby closer to the electrodes of the objective lens 340) than those charged particle in the charged particle beam 302 that are closer to the axis 304. Thus, the focussing effect of the objective lens 340 achieves a greater displacement of charged particles further from the axis 304. The condenser lens 320 may set the beam angle β or the position of the cross-over point C2 such that a proportion of the charged particle beam 302 passes through the aperture body 350, for example less 60%, preferably less than 50%, further optionally less than 40% of the charged particle beam 302. For some applications a proportion passing the aperture could be as low as 20% or even 10%. The distribution of charged particles in the charged particle beam 302 up-beam of the aperture body 350 may be less uniform at the edges of the charged particle beam 302 than at the centre of the charged particle beam 302. The distribution of charged particles in the charged particle beam 302 up-beam of the aperture body 350 may be a Gaussian distribution, for example. Passing such a charged particle beam 302 through the aperture body 350 may limit the lateral extent of the charged particle beam 302 so as to remove the edges of the charged particle beam 302. As such, only the centre of the charged particle beam 302 may pass through the aperture body 350. This may lead to an improvement in the uniformity of the charged particle beam 302 down-beam of the aperture body 350 compared to the charged particle beam 302 up-beam of the aperture body 350. Passing only a smaller proportion of the charged particle beam 302 through the aperture body 350 may also limit the current reaching the sample 208, which may be beneficial in some applications.

The aperture body 350 is preferably arranged down-beam of the condenser lens 320. The aperture body 350 may be arranged up-beam of the condenser lens and down-beam of the source lens 310. Having the aperture body 350 down beam of the condenser lens may be preferred because in that arrangement greater control of the beam and its beam spot may be achieved. The aperture body 350 is for passing at least a portion of the charged particle beam 302. The aperture body 350 may limit the lateral extent of the charged particle beam 302, for example in both the high-density mode of Fig. 3A and in the low-density mode of Fig. 3B. In some situations, the aperture body 350 may not limit the lateral extent of the charged particle beam 302, and all of the charged particle beam 302 may pass through the aperture body 302. When the charged particle beam 302 is divergent up-beam of the aperture body 350, the aperture body 350 may affect the beam angle of the charged particle beam 302, in that the beam angle β up-beam of the aperture body 350 is larger than the beam angle β' down-beam of the aperture body 350, as apparent from Fig. 3B.

Optionally, the blanking electrode 330 is arranged up-beam of the aperture body 350. The blanking electrode 330 may be arranged down-beam of the condenser lens 330. The blanking electrode 300 may deflect the charged particle beam 302 away from the axis 304 so as to prevent any portion of the charged particle beam 302 from passing the aperture body 350, for example towards sample 208.

The objective lens 340 is arranged down-beam of the aperture body 350. The objective lens 340 is controllable so as to adjust the focus of the charged particle beam 302. Using the objective lens 340 to adjust the focus of the charged particle beam 302 adjusts the lateral extent (or diameter) of the beam spot formed by the incidence of the charged particle beam 302 on the sample 208.

As shown in Fig. 3A, for example in the high-density mode, the objective lens 340 may be controllable so as to adjust the focus of the charged particle beam 302 such that the lateral extent (or diameter) of the beam spot is smaller than the lateral extent (or diameter) of the charged particle beam 302 at the objective lens 340.

Alternatively or additionally, for example in the low-density mode, the objective lens 340 may be controllable to manipulate the charged particle beam 302 such that the lateral extent (or diameter) of the beam spot is larger than the lateral extent (or diameter) of the charged particle beam 302 at the objective lens 340. This is shown, for example, in Fig. 3B. The objective lens 340 may be controllable so as to adjust the focus of the charged particle beam 302 to a cross-over point C3 up-beam of the sample 208, such that the lateral extent (or diameter) of the beam spot is larger than the lateral extent (or diameter) of the charged particle beam 302 at the objective lens 340. Preferably, the cross-over point C3 is located up-beam of a final element of the flood column 300, for example up-beam of the field lens 370 of the flood column 300. Creating the cross-over point C3 allows the lateral extent of the beam spot at the sample 208 to be increased compared to a situation in which no cross-over point C3 is created. This may be achieved because the cross-over point C3 may be positioned closer to the final element of the flood column 300 than the (virtual) focus point of a charged particle beam 208 that diverges directly down-beam of the objective lens 340. Thus a beam spot of more than 1mm and for example up to 20mm and even 50mm may be achieved.

The cross-over point C3 may be located such that the ratio d'/d of i) the distance d', along the axis 304, between the cross-over point C3 and the surface of the sample 208 and ii) the distance d, along the axis 304, between the centre of the objective lens 340 and the cross over-point C3, is greater than 1, preferably greater than 1.2, further preferably greater than 1.5, particularly preferably greater than 2. The ratio d'/d may be in the range from 1 to 10, preferably from 1.2 to 6, further preferably from 1.5 to 4, particularly preferably from 2 to 3. In other words, the magnification of the charged particle beam 302 by the objective lens 340 (from the objective lens 340 to the surface of the sample 208) may be in the range from 1 to 10, preferably from 1.2 to 6, further preferably from 1.5 to 4, particularly preferably from 2 to 3.

Optionally, the flood column 300 may comprise the scanning electrodes 360, for example a pair of scanning electrodes 360 (which may be referred to as a scanning deflector 360 or scanning element 360). The scanning electrodes 360 may be arranged or positioned down-beam of the aperture body 350. The scanning electrodes 360 may be arranged or positioned up-beam of the objective lens 340, as shown in Figs. 3A and 3B. Alternatively, the scanning electrodes 360 may be arranged down-beam of the objective lens 340, for example between the objective lens 340 and the field lens 370, or down-beam of the field lens 370.

The scanning electrodes 360, preferably a pair of scanning electrodes 360 (i.e. a scanning deflector), may be controllable so as to scan the charged particle beam 302 across the sample 208, for example in the high-density mode. The scanning electrodes 360 may be controllable to variably deflect the charged particle beam 302, for example in one dimension (from top to bottom in Fig. 3A). Optionally, further scanning electrodes may be provided to variably deflect the charged particle beam 302 angularly displaced around the axis 304, so as to scan the charged particle beam 302 across the sample 208. For example, each pair may scan the charged particle beam 302 along a different direction over the sample surface, preferably so that the charged particle beam 302is scanned in two orthogonal dimensions. Deflecting the charged particle beam 302 using the scanning electrodes to scan the sample 208 may be faster than moving the sample 208 relative to a stationary (i.e. non-scanned) charged particle beam 302. The faster speed achieved by scanning may be due to the smaller inertia of the charged particles compared to the motorized stage 209 and sample 208. Especially in situations in which the beam spot on the sample 208 is relatively small (such as in the high-density mode of Fig. 3A), it may thus be helpful to use the scanning electrodes 360 to achieve faster charged particle flooding of the sample 208 (or at least the portion of the sample 208 required to be flooded).

Alternatively or additionally, for example in the low-density mode, the scanning electrodes 360 may be controllable so as not to manipulate the charged particle beam 302. The scanning electrodes 360 may be controllable so as to retain or preserve the beam path of the charged particle beam 302, so as not to deflect the charged particle beam 302. The scanning electrodes 360 may be controllable in this manner, for example, in the low-density mode of operation of the flood column 300. In situations in which the beam spot on the sample 208 is relatively large (such as in the low-density mode of Fig. 3B), the use of the scanning electrodes 360 may reduce the maximum possible extent of the beam spot on the sample 208. This is because deflecting the charged particle beam 302 may require clearance between the charged particle beam 208 and the final element of the flood column. The use of the scanning electrodes 360 may thus be counterproductive to maximizing the lateral extent of the beam spot on the sample 208, for example in the low-density mode of Fig. 3B.

There may be provided the flood column 300 for charged particle flooding of the sample 208. The flood column 300 comprises a charged particle source 301 configured to emit a charged particle beam 302 along a beam path. The flood column 300 further comprises the source lens 301 arranged down-beam of the charged particle source 301. The flood column 300 further comprises the condenser lens 320 arranged down-beam of the source lens 301. The flood column 300 further comprises the aperture body 330 arranged down-beam of the source lens 310, preferably down-beam of the condenser lens 320. The aperture body 350 is for passing a portion of the charged particle beam 302. The flood column 300 further comprises the controller 50. The controller 50 selectively operates the flood column 300 in a high-density mode for charged particle flooding of a relatively small area of the sample 208, and a low-density mode for charged particle flooding of a relatively large area of the sample 208. The source lens 301 may be controllable so as to focus the charged particle beam 302 to the cross-over point C1 up-beam of the condenser lens 320 and to variably set the position of the cross-over point C1 along the a beam path.

There may be provided a method for charged particle flooding of the sample 208 using the flood column 300. The method comprises emitting the charged particle beam 302 along the beam path using the charged particle source 301. The method further comprises variably setting the beam angle α of the emitted charged particle beam 302 using the source lens 310 arranged down-beam of the charged particle source 301. The method further comprises adjusting the beam angle of the charged particle beam 302 using the condenser lens 320 arranged down-beam of the source lens 310. The method further comprises passing a portion of the charged particle beam 302 using the aperture body 350 arranged down-beam of the condenser lens 320.

There may be provided a method for charged particle flooding of the sample 208 using the flood column 300. The method comprises emitting the charged particle beam 302 along the beam path using the charged particle source 301. The method further comprises adjusting the beam angle α of the charged particle beam 302 using the condenser lens 320 arranged down-beam of the charged particle source 301. The method further comprises passing a portion of the charged particle beam 302 using the aperture body 350 arranged down-beam of the condenser lens 310. The method further comprises selectively operating the flood column 300 in a high-density mode for charged particle flooding of a relatively small area of the sample 208, and a low-density mode for charged particle flooding of a relatively large area of the sample 208.

There may be provided a method for charged particle flooding of the sample 208 using the flood column 300. The method comprises emitting the charged particle beam 302 along the beam path using the charged particle source 301. The method further comprises adjusting the beam angle α of the charged particle beam 302 using the condenser lens 320 arranged down-beam of the charged particle source 301. The method further comprises passing a portion of the charged particle beam 302 using the aperture body 350 arranged down-beam of the condenser lens 320. The method further comprises focusing the charged particle beam 302 to a cross-over point C3 up-beam of the sample 208 using the objective lens 340, such that the lateral extent of the charged particle beam 302 at the sample 208 is larger than lateral extent of the charged particle beam 302 at the objective lens 240.

As described earlier, the flood column 300 may comprise an objective lens 340 down-beam of the aperture body 350. The flood column 300 may also comprise additional components for manipulation of the charged particle beam 302 such as scanning elements 360 or scanning deflector 360and a field lens 370 as described in reference to Figs. 3A and 3B. As previously described, the objective lens 340 is positioned down-beam of the aperture body 350. The objective lens 340 may focus or defocus the charged particle beam 302. As described earlier with reference to Figs. 3A and 3B, the condenser lens 320 and objective lens 340 may be used to control the charged particle beam 302 to change the spot size on the sample 208. The field lens 370, for example positioned down-beam of the objective lens 340, may be used, as already described, to set the strength of the electric field between the field lens and the sample 208. The field lens 370 may suppress and/or extract secondary electrons generated by, and emanating from, the sample. This electric field affects the charged particles directed towards the sample 208, thereby affecting the charging speed and the charging level of the sample 208 during charged particle flooding (i.e. in terms of the maximum voltage of the sample 208 with respect to electrical ground after charged particle flooding).

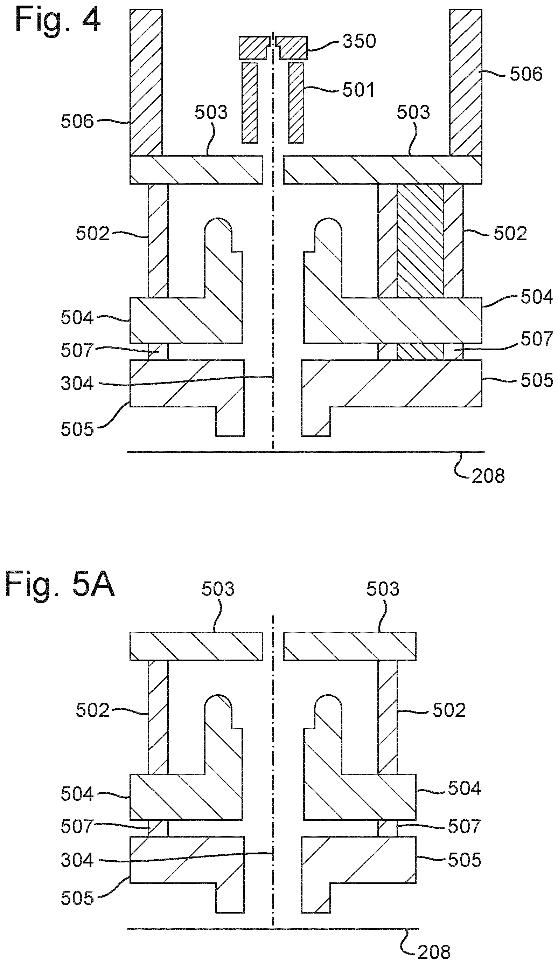

Fig. 4 schematically shows an aperture body 350 as well as the flood column 300 components that may be down-beam of the aperture body 350 according to an embodiment. The down-beam components may comprise a scanning deflector 501, a ground plane 503, an objective lens 504 and a final lens arrangement 505. During a flooding operation, a flooding beam of charged particles travels along a beam path 304 through the down-beam components to a sample 208. The beam path 304 may be the same as the axis 304.

The scanning deflector 501 may be arranged in the beam path 304 between the aperture body 350 and the ground plane 503. The scanning deflector 501 may be arranged to change and control the path of the flooding beam. The scanning deflector 501 may comprise electrodes for that generate electric fields for deflecting the flooding beam, according to known techniques. The scanning deflector 501 may be the same as the earlier described scanning electrodes 360 with reference to Figs. 3A and 3B. The scanning deflector 501 may have electrodes which may be arranged around the beam path 304. The electrodes may each be electrically connected. The electrodes of the deflector may be independently controlled or controlled together. The deflector electrodes may be independently connected to a voltage supply or to a common voltage supply.

The ground plane 503 is in the beam path between the aperture body 350 and the objective lens 504. The ground plane 503 may be an annular metallic disc with a central aperture so that the flooding beam may pass through it. The ground plane 503 may be at a local ground potential, which may be 0V. The effect of the ground plane 503 may be to substantially shield the region down-beam from the ground plane 503 from the electric fields generated by the scanning deflector 501. If no ground plane 503 is used, the electric fields generated by the scanning deflector 501 may extend to the region between the scanning deflector 501 and the objective lens 504. This may result in the electric field in this region being rotationally asymmetric (i.e. not symmetric). A consequence of this may be that, during a flooding operation, the flooding beam spot on the sample 208 is rotationally asymmetric. This deformation of the flooding beam spot may degrade flooding beam spot. This deformation may degrade the flooding process and/or the performance of the flooding by the flooding beam spot. In particular, the asymmetry may reduce the uniformity of the current density in the beam.

In an embodiment, the ground plane 503 and scanning deflector 501 may effectively be parts of the same component for manipulating the flooding beam. That is to say, the ground plane 503 may effectively be the down-beam surface of the deflector. The presence of the ground plane 503 may therefore complement the operation of the scanning deflector 501.

As shown in Fig. 4, at least some of the components of the flood column may be comprised by a housing 506. In an embodiment the housing 506 may comprise the aperture body 350. Preferably, the housing 506 also comprises the scanning deflector 501. Preferably, the housing 506 also comprises the ground plane 503. A down-beam end of the housing 506 may be at the ground plane 503. The ground plane 503 may be part of the housing 506. It may be impractical, and even impossible, for the housing 506 to extend down-beam of the ground plane 503 due to volume and/or position restrictions within the flood column. This may be because, for example, of the positioning of the flood column with respect to the primary column. In particular, this may because, for example, of the positioning with respect to the wall of the main chamber, such as the positioning of a portion of the electron-optical design, and the elements of it, with respect to the interface of the main chamber. That is to say, if the housing 506 extends down-beam of a particular position in the electron-optical path of the flood column, such as the ground plane 503, configuration and/or performance compromises may need to be made to other components in the charged particle apparatus. In such an embodiment, the housing 506 may therefore only extend up-beam of the ground plane 503, i.e. not down-beam of the ground plane 503. The effect of the housing 506 may be to shield the part of the beam path 304 that is comprised by the housing 506. Accordingly, when the housing 506 extends down to certain location in charged particle beam path of the flood column, such as the ground plane 503, and no further, all of the beam path 304 that is up-beam of the certain location, such as the ground plane 503, may be shielded by the housing 506. In providing the shielding to a particular location in the beam path in the flood column, such as the ground place 503, which may correspond to the wall of the main chamber in view of limited volume, may beneficial that the shielding is limited to shielding of the flood column outside the main chamber, and the shielding does not extend within the main chamber.

In order to provide shielding, the housing 506 walls may comprise an alloy with a high permeability. The housing 506 walls may comprise a mu-metal. The housing 506 walls may be configured to have a suitable thickness for shielding the beam. The housing 506 walls may comprise a mu metal alloy, or alternatively an alloy with a lower permeability than mu-metal but which provides sufficient shielding. Such an alloy may be less expensive than mu-metal. The thickness of the housing 506 walls may be larger than if mu-metal is used so that effective shielding is still provided. In alternative embodiment, the shielding may be achieved by a shielding wall within and apart from the chamber wall. However in view of limited volume such an arrangement may be impractical if not impossible. Having the chamber wall serve as a shield is therefore beneficial.

The objective lens 504 may be configured to contribute to the deceleration of the flooding beam. In the direction of the beam path 304, the objective lens 504 may have a high aspect ratio. The objective lens 504 may be an electrostatic lens, i.e. an E-field lens. The electrodes of the objective lens 504 may comprise monolithic titanium. In having a high aspect ratio, the objective lens 504 may extend along the beam path 304. The objective lens 504 thus beneficially provide electrostatic shielding to the part of the beam path 304 along which it extends. It should be noted that references to electrostatic lenses throughout the present document may more generally refer to structures which contribute to an electrostatic lensing function. The lensing function may arise due to an electrical field generated between two or more lens bodies, thus comprising by one or more lenses operated at the operating potentials thereof. This is described in more detail later.

The final lens arrangement 505 may be adjacent to the sample 208. The final lens arrangement 505 may be an electrostatic lens, i.e. an E-field lens. The electrodes of the final lens arrangement 505 may comprise monolithic titanium.

The objective lens 504 and final lens arrangement 505 may respectively be the earlier described objective lens 340 and field lens. In the direction of beam path 304, the objective lens 504 may be up-beam of the final lens arrangement 505. The objective lens 504 may be separated from the final lens arrangement 505.

The objective lens 504 and final lens arrangement 505 may together be referred to as a lens arrangement 504, 505. The lens arrangement 504, 505 is held in position by one or more lens supports 502, 507 that extend down-beam from an anchor body of the lens arrangement 504, 505. The anchor body may be an element, or arrangement of elements, which directly support or hold the lens supports 502, 507. The only function of the anchor body may be to hold the lens supports 502, 507. Alternatively, the anchor body may have other functions in addition to holding the lens supports 502, 507. The anchor body may therefore be comprised within the housing 506. The anchor body may be or comprise any component that the housing 506 comprises, such as the aperture body 350 and the ground plane 503. In particular, the one or more lens supports 502, 507 may extend down-beam from the aperture body 350 or ground plane 503, which may be part of the housing 506. The lens arrangement 504, 505 is therefore suspended from the housing 506 by the one or more lens supports 502, 507 for example connected via the anchor body. Each lens support 502, 507 may comprise a first part 502 that extends from the housing 506 to the objective lens 504. Each lens support 502, 507 may also comprise a second part 507 that extends from the objective lens 504 to the final lens arrangement 505. The first part 502 of each lens support may define the separation between the objective lens 504 and the housing 506. The second part 507 of each lens support may define the separation between the final lens arrangement 505 and the objective lens 504. The one or more lens supports 502, 507 are therefore configured to position the objective lens 504 and the final lens arrangement 505 relative to each other and the housing 506.

The one or more lens supports 502, 507 are required to hold the lens arrangement 504, 505 in its position along the beam path 304. Each lens support 502, 507 according to embodiments extends along the beam path 304 from the housing 506. The use of one or more lens supports 502, 507 according to embodiments may be preferable over other techniques for supporting the lens arrangement 504, 505. In particular, as described earlier, volume restrictions within the flood column may prevent the housing 506 from extending down-beam from the ground plane 503. That is to say, if the housing 506 extends down-beam from the ground plane 503 to the lens arrangement 504, 505, the volume occupied by the housing 506 may force substantial design and/or performance compromises on other components in the apparatus. Volume and positioning restrictions, as well as movement requirements, may also prevent other types of support structures of the lens arrangement 504, 505, such as a support structure that is orthogonal to the beam path 304.

The one or more lens supports 502, 507 according to embodiments may be configured so that their interference on the operation of the flood column is minimal. Different parts of each lens support 502, 507 may be in contact with the ground plane 503, objective lens 504 and the final lens arrangement 505. There may be large potential differences between each of the ground plane 503, objective lens 504 and the final lens arrangement 505. In order for the same lens support 502, 507 to be in contact with components at different operating voltages, each lens support 502, 507 according to embodiments may be an electrical insulator. The operation at different voltages of the ground plane 503, objective lens 504 and the final lens arrangement 505 will therefore be substantially unaffected by the physical contact with each lens support 502, 507.

The properties of the flooding beam, such as its power, flooding spot size and positioning of the spot of the flooding beam on the sample are important. The accuracy with which the properties of the flooding beam may be controlled are also important. A problem with each lens support 502, 507 being an electrical insulator is that, over time, electric charges may build-up on the surface of the lens support 502, 507. Electric fields from charge build-up on a surface near the flooding beam path 304 may potentially have an effect on the flooding beam path 304. This may adversely affect the operation of the flooding beam, such as the ability to achieve different parameters and/or settings of the flooding beam for performance specifications. Embodiments therefore include techniques for allowing a flooding beam to be controlled with sufficient accuracy, for example to achieve standards of flooding of the sample. In particular, each lens support 502, 507 according to an embodiment may be configured so that any charge build-up on its surface may have little, or substantially no, effect on the flooding beam path 304. For example, each lens support 502, 507 according to embodiments may be a relatively narrow elongate structure. This reduces the amount of lens support 502, 507 surface, that may be charged, in the vicinity of the flooding beam path 304.

As shown in at least Fig. 4, part of each lens support 502, 507 may be in the direct line of sight of at least a portion of the flooding beam path 304. To reduce the extent that a surface of each lens support 502, 507 is in direct line of sight of at least a portion of the flooding beam path 304, part of the objective lens 504 may be configured to extend along the beam path 304 in a direction away from the final lens arrangement 505. This reduces the separation between the down-beam end of the housing 506, which may be the ground plane 503, and the up-beam end of the objective lens 504. The effect of this is also to reduce the length of the flooding beam path 304 that is in direct line of sight with a surface of the lens support 502, 507. The extent of charging of each lens support 502, 507 surface on the flooding beam is thereby reduced. The objective lens 504 and final lens arrangement 505 may be configured so that they encircle between 50% and 90% of the longitudinal extent of the flooding beam path 304 between the ground plane 503 and the sample 208.

Each lens support 502, 507 and the lens arrangement 504, 505 may be geometrically shaped and positioned with respect to the flooding beam path 304 and each other such that, in use, any charging of a surface of a lens support 502, 507 has no substantial influence on the flooding beam, in terms of path, focus and/or aberrations.

Embodiments include the use of a single lens support 502, 507. However, embodiments preferably use a plurality of lens supports 502, 507 because this may provide a more secure attachment of the lens arrangement 504, 505 to the housing 506. The number of lens supports 502, 507 may two, three or more.

As shown in Fig. 4, the lens supports 502, 507 may have different structures. The lens support 502, 507 on the left of Fig. 4 may have a circular or rectangular cross-section, for example it may be a solid cylinder. The lens support 502, 507 on the right of Fig. 4 may be a hollow structure, for example it may be a tube. The outer perimeter of the lens support 502, 507 on the right may have circular or rectangular cross-section. The lens support 502, 507 on the left has a smaller outer dimension, i.e. outer diameter or width, than the lens support 502, 507 on the right. An advantage of the lens support 502, 507 on the left is that it has a smaller external surface for charge build-up than the lens support 502, 507 on the right. An advantage of the lens support 502, 507 on the right is that it is a stronger structure than the lens support 502, 507 on the left. A further advantage of the lens support 502, 507 on the right is that the central channel of the tubular structure may be used as a passage for wires/cables that provide a power supply to lens arrangement 504, 505, effectively shielding the flooding beam path from the cables. The use of lens supports 502, 507 with different structures increases the options of how lens supports 502, 507 may be provided given any volume and/or positioning restraints.

Fig. 5A shows an alternative implementation of lens supports 502, 507 according to an embodiment. The lens support 502, 507 comprises two lens supports 502, 507. Each lens support 502, 507 may be the same as each other. Each lens support 502, 507 may be the same the lens support 502, 507 as shown on the left in Fig. 4. That is to say, each lens support 502, 507 may be an elongate structure with a circular or rectangular cross-section, for example it may be a solid cylinder. Beneficially, the influence of charge build-up on the surfaces of the supports is similar and thus their influence on the flooding beam path is substantially equal. Further, in having two elongate structures, surface area of the structures exposed to the beam path is reduced, if not minimized.

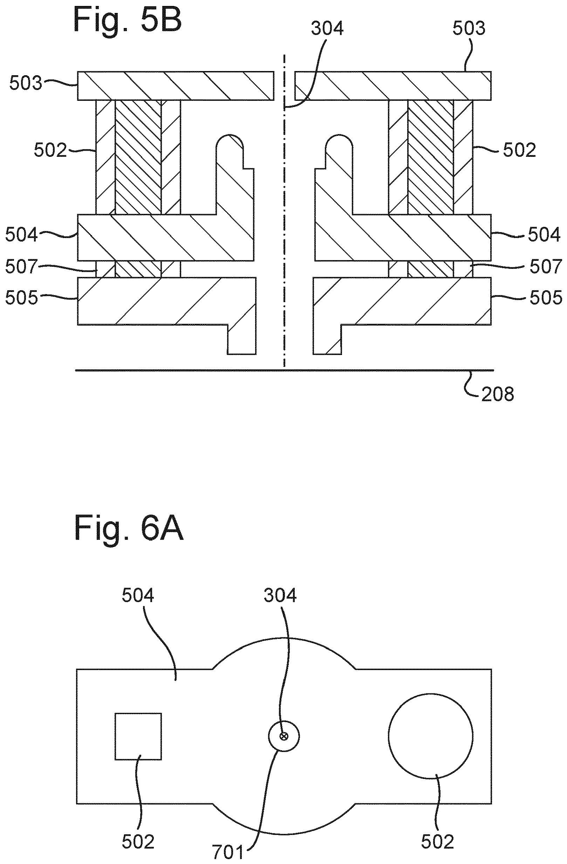

Fig. 5B shows another alternative implementation of lens supports 502, 507 according to an embodiment. The lens support 502, 507 comprises two lens supports 502, 507. Each lens support 502, 507 may be the same as each other. Each lens support 502, 507 may be the same the lens support 502, 507 as shown on the right in Fig. 4. That is to say, each lens support 502, 507 may be an elongate structure. Each lens support 502, 507 may be a hollow structure, such as a tube, or a solid structure. The outer perimeter of each lens support 502, 507 may have circular or rectangular cross-section. Beneficially, the influence of charge build-up on the surfaces of the supports is similar and thus their influence on the flooding beam path is substantially equal. In having more than one of the support structures as hollow tubes, more options exist for locating the cabling.

Fig. 6A schematically shows a plan view cross-section through the objective lens 504 in an embodiment. Fig. 6A may be a cross-section through the objective lens 504 in the embodiment shown in Fig. 4. The objective lens 504 comprises an aperture 701 so that the flooding beam 304 may pass through the objective lens 504. The aperture 701 may be rotationally symmetric. As shown in Fig. 6A, the outer perimeter of the lens support 502, 507 on the left may be substantially square in cross-section. The outer perimeter of the lens support 502, 507 on the right may be substantially circular in cross-section. The implementation of the lens supports 502, 507 is therefore asymmetric. The use of an asymmetric implementation of the lens supports 502, 507 provides more flexibility in how the lens arrangement 504, 505 may be supported given volume and/or positioning restraints. The different extent that the charging of each lens support 502, 507 affects the flooding beam may be negligible and/or compensated for by the down-beam components of the aperture body 350.

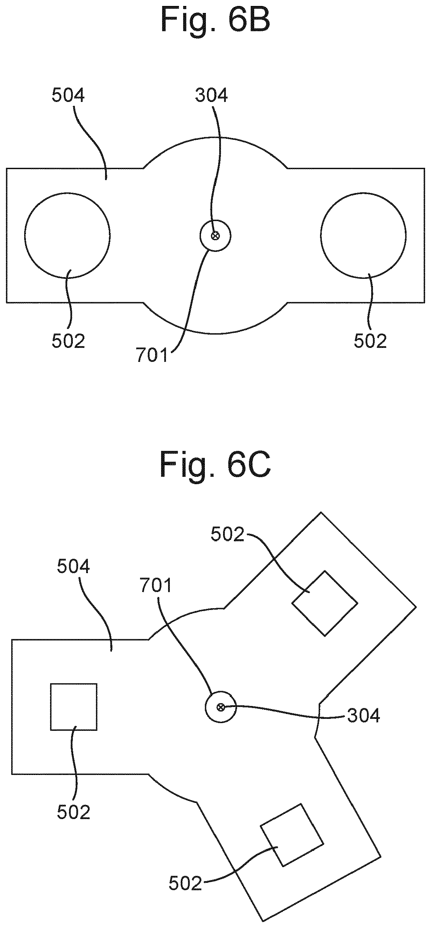

Fig. 6B schematically shows a plan view cross-section through the objective lens 504 in another embodiment. Fig. 6B may be a cross-section through the objective lens 504 in the embodiment shown in Fig. 5B. The objective lens 504 comprises an aperture 701 so that the flooding beam 304 may pass through the objective lens 504. The aperture 701 may be rotationally symmetric. As shown in Fig. 6B, the outer perimeter of the lens supports 502, 507 may both be substantially circular in cross-section. The lens supports 502, 507 in Fig. 6B may have larger diameters/widths than the lens supports 502, 507 in Fig. 6A. The lens supports 502, 507 in Fig. 6B may therefore be structurally stronger than those in Fig. 6A. However, the lens supports 502, 507 in Fig. 6A may have a larger chargeable surface for affecting the flooding beam. The implementation of the lens supports 502, 507 in Fig. 6B is symmetric. The use of an symmetric implementation of the lens supports 502, 507 ensures that the charging of each lens support 502, 507 affects the flooding beam by about the same extent. The effect of the charging on the flooding beam may therefore be negligible and/or compensated for by the down-beam components of the aperture body 350. The use of lens supports 502, 507 that are substantially the same as each other may also have structural advantages. For example, the response of the lens arrangement 504, 505 to vibrational disturbances may be improved if the strength and stability of each lens support 502, 507 is the same.

Fig. 6C schematically shows a plan view cross-section through the objective lens 504 in another embodiment. The objective lens 504 comprises an aperture 701 so that a flooding beam 304 may pass through the objective lens 504. As shown in Fig. 6C, there are three lens supports 502, 507. The outer perimeter of each lens support 502, 507 may be substantially square in cross-section. Alternatively, the outer perimeter of each lens support 502, 507 may be substantially rectangular in cross-section so as to increase the structural stability and strength of each lens support 502, 507. All of the supports may be tubes. All of the lens supports 502, 507 may be substantially the same. Alternatively, different lens supports 502, 507 may be used. Advantages of using more than two lens supports 502, 507 may include the lens arrangement 504, 505 being provided with a stronger and more stable support. Disadvantages may include the lens supports 502, 507 occupying more volume and the amount of chargeable surface increasing.

Accordingly, embodiments include a number of different arrangements of lens support 502, 507. In particular, embodiments include there being two lens supports 502, 507 arranged on opposing sides of the beam path 304. Alternatively, embodiments include there being three or more lens supports 502, 507 arranged around the beam path 304. The three or more lens supports 502, 507 may be arranged angularly equidistant around the beam path 304. In embodiments with a plurality of lens supports 502, 507, the lens supports 502, 507 may be substantially equidistantly radially positioned from the beam path 304. The rotationally symmetric arrangement of lens supports 502, 507 may reduce the extent that the symmetry of the flooding beam is affected by the charging of the lens supports 502, 507. Each lens support 502, 507 may have a radial surface portion most proximate to the beam path 304 and the radial surface portions of the lens supports 502, 507 may be substantially equidistantly radially positioned from the beam path 304. In embodiments with a plurality of lens supports 502, 507, the cross-sections of the lens supports 502, 507 may be similar. Accordingly, each lens support 502, 507 may have substantially the same dimensions, i.e. diameter, width and/or length.

Embodiments include a number of different configurations of the down-beam components from the aperture body 350. For example, the separation along the beam path 304 between the ground plane 503 and the most up-beam part of the objective lens 504 may be in the range 2mm to 30mm, and preferably 6mm to 12mm. The separation along the beam path 304 between the ground plane 503 and the most down-beam part of the objective lens 504 may be in the range 20mm to 50mm, and preferably 30mm to 40mm. The separation along the beam path 304 between the ground plane 503 and the most up-beam part of the final lens arrangement 505 may be in the range 30mm to 60mm, and preferably 25mm to 50mm. The separation along the beam path 304 between the objective lens 504 and the final lens arrangement 505 may be in the range 1mm to 10mm, and preferably 2mm to 8mm

When the flood column is in use, the potential difference between the ground plane 503 and objective lens 504 may be in the range 20kV to 50kV, and preferably 25kV to 30kV. The potential difference between the objective lens 504 and final lens arrangement 505 may be in the range 0V to lOkV, and preferably 3kV to 6kV. The potential difference between the final lens arrangement 505 and the sample 208 is in the range -5kV to lOkV, and preferably -2kV to 5kV.

The inventors found that having a flood column with down-beam components having components and a design using these numerical ranges provides a flood column with advantageous performance. Some of the performances characteristics are as herein described.

Embodiments include a number of modifications and variations to the above-described techniques.

In particular, the aperture body 350 may be any aperture body 350 that is configured to blank and/or shape the flooding beam. Accordingly, the aperture body 350 may have a different design from the aperture body 350 that is shown in Figs. 3A and 3B, for example as disclosed and described in PCT/EP2021/054983 filed on 1 March 2020 of which the description relevant to aperture designs and configurations is hereby incorporated by reference.

The use of the ground plane 503 as one down-beam components of the aperture body 350 is optional. Accordingly, embodiments include there being no ground plane 503. In such embodiments, the down-beam end of the housing 506 may be at the aperture body 350 or the scanning deflector 501.

Throughout the present document lenses are referred to. These may be references to the lens structures, such as electrodes, and/or the lensing effect caused by the fields generated by the lens structures. In particular, a voltage supply may be electrically connected to a component so as to supply a potential or potential difference to the component which may be different from a component adjacent in the beam path 304. For example, a lens may have a potential applied to it by a voltage supplier. The applied potential may be applied as a potential difference between a surface of the lens and the beam path 304. The surface of the lens may be generally orthogonal to the beam path 304. The potential applied to the surface of the lens, for example, may operate between the surface of the lens and a surface of an adjacent component in the beam path 304 that may be generally orthogonal to the beam path 304. The adjacent component is electrically connected and it may be connected to a voltage supply which applies a potential to the adjacent component such that a potential is applied to the surface of the adjacent component. A controller may be connected to the voltage supplies of the lens and the adjacent component to control their operation and thus control of the beam along the beam path 304.

Embodiments may include a flood column for projecting a charged particle flooding beam along a beam path 304 towards a sample 208 to flood the sample 208 with charged particles prior to assessment of the flood sample 208 using an assessment column. The flood column comprises: an aperture body 350, an electro-magnetic shield, a lens arrangement 504, 505 and a lens support 502, 507. The aperture body is arranged in the beam path 304 and is configured to blank and/or shape the charged particle flooding beam. The electro-magnetic shield is configured to shield at least part of the beam path 304. The lens arrangement 504, 505 is arranged in the beam path 304 down-beam of the aperture body 350. The lens support 502, 507 is arranged between the aperture body 350 and the lens arrangement 504, 505 and configured to support the lens arrangement 504, 505 relative to the aperture body 350. The lens support 502, 507 may comprise an insulator. The shield may comprises an end, the shielding extending along the beam path 304 up to the end, the end positioned between the aperture body 350 and at least part of the lens arrangement 504, 505. The end of the shield may be up-beam of the lens arrangement 504, 505, preferably the end is down-beam of the aperture body 350, and preferably the end is no further down-beam than a down-beam surface of the aperture. The shield may be comprised in a chamber wall of the flood column, preferably the chamber wall comprises mu-metal or an alloy capable of electromagnetic shielding

Embodiments may further include a charged particle assessment system e.g. a tool, comprising: a stage, a charged particle system, and a flood column. The stage is configured to support a sample 208. The charged particle system for assessing the sample 208; the charged particle assessment system is configured to project a charged particle beam towards a sample 208 and to detect charged particles emanating from the sample 208. The flood column according to the embodiments is configured to project a charged particle flooding beam towards the sample 208 so as to flood the sample 208. The flood column may be configured to project a charged particle flooding beam to the sample 208 to flood the sample 208 prior to assessment of the flood sample 208 by the charged particle system.

The primary column of the charged particle assessment tool may be as described and shown with respect to Fig. 2. In another embodiment the electron-optical column 40 may comprise alternative and/or additional components on the charged particle path, such as lenses and other components some of which have been described earlier with reference to FIGs. 1 and 2. In particular, embodiments include an electron-optical column 40 that divides a charged particle beam from a source into a plurality of sub-beams. A plurality of respective objective lenses may project the sub-beams onto a sample. In some embodiments, a plurality of condenser lenses are provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The condenser lenses, objective lenses and/or detector may be formed as MEMS or CMOS devices.

Embodiments further include a flood column for projecting a charged particle flooding beam along a path towards a sample 208, the flood column comprising: an aperture body 350, a final lens arrangement 505, and an insulating support. The aperture body 350 is for blanking and shaping the charged particle flooding beam. The final lens arrangement 505 is adjacent the sample 208. The insulating support is between the aperture body 350 and a surface of the final lens arrangement 505, the surface facing the sample 208. The support and lens arrangement 504, 505 are geometrically shaped and positioned with respect to the beam path 304 and each other such that charging of a surface of the support has minimal influence on the flooding beam, in terms of e.g. path, focus and aberrations.

The flood column of embodiments may comprise: a charged particle source, a source lens, a condenser lens and a controller. The charged particle source is configured to emit a charged particle beam along the beam path. The source lens is arranged down-beam of the charged particle source. The condenser lens is arranged down-beam of the source lens, wherein the aperture body is down beam of the condenser lens and is configured to pass a portion of the charged particle beam. The controller is configured to selectively operate the flood column in a high-density mode for charged particle flooding of a relatively small area of the sample, and a low-density mode for charged particle flooding of a relatively large area of the sample.

Embodiments are particularly appropriate for operation with a high energy flooding beam in which there may be substantial power dissipation in the aperture body 350. Embodiments include the electron source 301 of the flood column operating at a high voltage, for example more than 20 keV preferably more than 30 keV, 40keV or 50keV. The electrons from the electron source 301 have a high landing energy for example relative to a sample 208 for example on the sample holder 207. Preferably the electron source 301 of the flood column operates at the same, or at least substantially the same operating voltage as the electron source 201 of the primary column. Electrons from the electron source 301 of the flood column 300 desirably have the same, or at least a substantially similar landing energy to electrons emitted by the electron source 201 of the inspection tool 200. Having the sources 201, 301 of both flood column and the primary column at substantially the same operating voltage is desirable. This is because the sample 208, and thus preferably the substrate support and desirably the moveable stage 209 are set at the same operating voltage for inspection and/or measurement and flooding. That is they may be biased to the source of the primary column during inspection and the source of the flood column during flooding. The relative potential between the primary source the stage is set at high voltage. Flood columns, such as those that are commercially available, have an operating voltage substantially less than the high voltage of the inspection tool 200. Such a stage cannot be maintained at high voltage during flooding, since the stages are biased relative to an operating source, whether of the flood column or the primary column. The biasing of the stage should therefore change to suit the source next to operate. For a commercially available flood column, the source an can be set to a potential to near ground potential,.

The stage may be moved between a flooding position and an inspection/measurement position. It takes time to move the moveable stage 209 between a flooding position when the sample 208 is in the beam path 304 of the flood column, and an inspection position when the sample 208 is in the beam path 304 of the primary column. Yet the time taken to adjust the stage potential between inspection and flooding settings for a typical commercial flood column and high voltage inspection tool, may take longer than the movement between the flooding and inspection positions. The change in voltage can take as long as minutes. Therefore, there is a significant throughput improvement in having a flood column having at least a similar operating voltage to the primary column; this is even for an inspection or measurement tool with a separate flood column having its own flooding position apart from an inspection position. Another benefit is that in reducing the time between flooding and inspection and/or measurement, the flooding effect remains and the risk of it disappearing before inspection/measurement is reduced if not prevented.

An assessment tool according to an embodiment of the invention may be a tool which makes a qualitative assessment of a sample 208 (e.g. pass/fail), one which makes a measurement such as a quantitative measurement (e.g. the size of a feature) of a sample 208 or one which generates an image of map of a sample 208. Examples of assessment tools are inspection tools (e.g. for identifying defects), review tools (e.g. for classifying defects) and metrology tools.

Reference of the charged particle beam 302 up-beam or down-beam of an element includes directly up-beam or directly down-beam of that element. Reference to a first element being up-beam and down-beam of a second element may mean directly up-beam or directly down-beam, but may also, where appropriate, include embodiments in which other elements are provided between the first element and the second element.

Reference to a component being controllable to manipulate the charged particle beam 302 in a certain manner includes the controller 50 controlling the component so as to manipulate the component in this manner, as well as other controllers or devices (e.g. voltage supplies) controlling the component so as to so as to manipulate the component in this manner. For example, a controller may be electrically connected to a component, a selection of the components or all the electrostatic components of the flood column. A voltage supply may be electrically connected to a component so as to supply a potential or potential difference to the component which may be different from a component adjacent in the beam path 304. For example, a lens may have a potential applied to it by a voltage supplier. The applied potential may be applied between a surface of the lens and the beam path 304. The surface of the lens may be generally orthogonal to the beam path 304. The potential applied to the surface of the lens, for example, may operate between the surface of the lens and a surface of an adjacent component in the beam path 304 that may be generally orthogonal to the beam path 304. The adjacent component is electrically connected and it may be connected to a voltage supply which applies a potential to the adjacent component such that a potential is applied to the surface of the adjacent component. The controller may be connected to the voltage supplies of the lens and the adjacent component to control their operation and thus control of the beam along the beam path 304. Note the components of the flood column include a deflector such as a scanning deflector 501. Such a deflector may have electrodes which may be arranged around the beam path 304. The electrodes each are electrically connected. The electrodes of the deflector may be independently controlled or controlled together. The deflector electrodes may be independently connected to a voltage supply or to a common voltage supply.

Reference to a cross-over point includes a real cross-over point that is achieved by focusing the charged particle beam 302 to the cross-over point (such as the cross-over points C1, C2 and C3 in Fig. 3A and 3B). Where appropriate, reference to a cross-over point may also include a virtual cross-over point that is located up-beam of an element that diverges the charged particle beam 302. The virtual cross-over point is the point from which the charged particle beam 302 appears to diverge.

All references to beam angles in this specification are the maximum angular displacement across the beam cross-section. An alternative definition of beam angle could be the maximum angular displacement of the beam relative to the electron-optical axis, shown in dotted lines in Figs. 3A and 3B. The alternative definition of beam angle, relative to the axis, would be half of that beam angle provided herein.

Embodiments include the following numbered clauses.
Clause 1: A flood column for projecting a charged particle flooding beam along a beam path towards a sample to flood the sample with charged particles prior to assessment of the flooded sample using an assessment column, the flood column comprising: an anchor body arranged along the beam path; a lens arrangement arranged in a down beam part of the flood column; and a lens support arranged between the anchor body and the lens arrangement; wherein the lens support is configured to position the lens arrangement and the anchor body relative to each other; the lens support comprises an electrical insulator; and the lens support is in the direct line of sight of at least a portion of the beam path in the down beam part.
An alternative, or additional, Clause 1 is: A flood column for projecting a charged particle flooding beam along a beam path towards a sample to flood the sample with charged particles prior to assessment of the flooded sample using an assessment column, the flood column comprising: an aperture body arranged in the beam path and configured to blank and/or shape the charged particle flooding beam; an electro-magnetic shield configured to shield at least part of the beam path; a lens arrangement arranged in the beam path down-beam of the aperture body; and a lens support arranged between the aperture body and the lens arrangement and configured to support the position of the lens arrangement relative to the aperture body; wherein the lens support comprises an electrical insulator; and the shield comprises a down-beam end, that is positioned between the aperture body and at least part of the lens arrangement, and the shield is configured to extend along the beam path up to the down-beam end.
Clause 2: The flood column according to clause 1, wherein the lens arrangement comprises a final lens arrangement that is arranged adjacent to the sample.
Clause 3: The flood column according to clause 2, wherein the final lens arrangement is an electrostatic lens.
Clause 4:The flood column according to clause 2 or 3, wherein the lens arrangement further comprises an objective lens; wherein, in the direction of beam path, the objective lens is separated from the final lens arrangement; and the objective lens is arranged up-beam of the final lens arrangement.
Clause 5: The flood column according to clause 4, wherein the objective lens is configured to contribute to the deceleration of the flooding beam.
Clause 6: The flood column according to clause 4 or 5, wherein, in the direction of the beam path, the objective lens has a high aspect ratio.
Clause 7: The flood column according to any of clauses 4 to 6, wherein part of the objective lens is configured to extend along the beam path in a direction away from the final lens arrangement so as to reduce the extent of the lens support that is in direct line of sight of at least a portion of the beam path.
Clause 8: The flood column according to any of clauses 4 to 7, wherein the objective lens is an electrostatic lens.
Clause 9: The flood column according to any of clauses 4 to 8, wherein the objective lens and final lens arrangement are secured to each other by at least part of the lens support.
Clause 10: The flood column of any preceding clause, wherein the anchor body is an aperture body arranged in the beam path and configured to blank and/or shape the charged particle flooding beam.
Clause 11: The flood column of clause 10, wherein the lens support is supported by the aperture body.
Clause 12: The flood column according to any preceding clause, further comprising a scanning deflector arranged in the beam path between the aperture body and the lens arrangement.
Clause 13: The flood column according to clause 12, further comprising a ground plane with an aperture for passing the flooding beam; wherein the aperture of the ground plane is in the beam path between the scanning deflector and the lens arrangement.
Clause 14: The flood column according to clause 11, wherein the ground plane is configured to substantially shield a region, that is down-beam from the ground plane, from the electric fields of the scanning deflector.
Clause 15: The flood column according to clause 12, wherein part of the beam path is shielded; and the part of the beam path that is shielded is up-beam of the aperture body and, optionally, up beam of the ground plane.
Clause 16: The flood column of clause 15, wherein a down beam end of the shielding of the beam path defines the down beam part of the flood column.
Clause 17: The flood column according to any preceding clause, further comprising a flood column housing; wherein the lens support extends between the flood column housing and the lens arrangement.
Clause 18: The flood column according to clause 17, wherein the wherein the flood column housing comprises the aperture body, and, optionally, the ground plane and/or scanning deflector.
Clause 19: The flood column according to clause 17 or 18, wherein the flood column housing comprises a down-beam end; and the flood column housing is arranged to shield the part of the beam path up to the down-beam end.
Clause 20: The flood column according to any of clauses 17 to 19, wherein the walls of the flood column housing comprise an alloy with a high permeability and have a wall thickness for shielding the beam.
Clause 21: The flood column according to any preceding clause, wherein there are a plurality of lens supports configured to position the lens arrangement and the aperture body; and each lens support comprises an electrical insulator.
Clause 22: The flood column according to clause 21, wherein there are two lens supports arranged on opposing sides of the beam path.
Clause 23: The flood column according to clause 21, wherein there are three or more lens supports that are arranged around the beam path, and optionally arranged angularly equidistant around the beam path.
Clause 24: The flood column according to any of clauses 21 to 23, wherein the lens supports are equidistantly radially positioned from the beam path.
Clause 25: The flood column according to any of clauses 21 to 24, wherein each of the lens supports has a radial surface portion most proximate to the beam path; and the radial surface portions of the lens supports are equidistantly radially positioned from the beam path.
Clause 26: The flood column according to any of clauses 21 to 25, wherein at least one lens support is a tubular structure.
Clause 27: The flood column according to any of clauses 21 to 26, wherein the lens supports have respective cross-sections, and wherein all of the cross-sections are similar.
Clause 28: The flood column according to any of clauses 21 to 27, wherein each lens support has substantially the same diameter, width and/or length.
Clause 29: The flood column according to any of clauses 21 to 28, wherein, in plan view, the maximum width of one of the lens arrangements is different from the maximum width of one of the other lens arrangements.
Clause 30: The flood column according to clause 13 when dependent on clause 4, or any clause dependent thereon, wherein the separation along the beam path between the ground plane and the most up-beam part of the objective lens is in the range 2mm to 30mm, and preferably 6mm to 12mm.
Clause 31: The flood column according to clause 13 when dependent on clause 4, or any clause dependent thereon, wherein the separation along the beam path between the ground plane and the most down-beam part of the objective lens is in the range 20mm to 50mm, and preferably 30mm to 40mm.
Clause 32: The flood column according to clause 13 when dependent on clause 2, or any clause dependent thereon, wherein the separation along the beam path between the ground plane and the most up-beam part of the final lens arrangement is in the range 30mm to 60mm, and preferably 25mm to 50mm.
Clause 33: The flood column according to clause 4, or any clause dependent thereon, wherein the separation along the beam path between the objective lens and the final lens arrangement is in the range 1mm to 10mm, and preferably 2mm to 8mm.
Clause 34: The flood column according to clause 13, or any clause dependent thereon, wherein between 50% and 90% of the longitudinal extent of the beam path between the ground plane and the sample is encircled by the lens arrangement.
Clause 35: The flood column according to clause 13 when dependent on clause 4, or any clause dependent thereon, wherein, in use, the potential difference between the ground plane and objective lens is in the range 20kV to 50kV, and preferably 25kV to 30kV.
Clause 36: The flood column according to clause 4, or any clause dependent thereon, wherein, in use, the potential difference between the objective lens and final lens arrangement is in the range 0V to lOkV, and preferably 3kV to 6kV.
Clause 37: The flood column according to clause 2, or any clause dependent thereon, wherein, in use, the potential difference between the final lens arrangement and the sample is in the range -5kV to lOkV, and preferably -2kV to 5kV.
Clause 38: The flood column according to any preceding clause, wherein each lens support and the lens arrangement are geometrically shaped and positioned with respect to the beam path and each other such that, in use, any charging of a surface of a lens support has no substantial influence on the flooding beam, in terms of path, focus and/or aberrations.
Clause 39: The flood column according to any preceding clause, wherein electrodes of the lens arrangement comprise monolithic titanium.
Clause 40: A flood column for projecting a charged particle flooding beam along a beam path towards a sample to flood the sample with charged particles prior to assessment of the flooded sample using an assessment column, the flood column comprising: an aperture body arranged in the beam path and configured to blank and/or shape the charged particle flooding beam; an electro-magnetic shield configured to shield at least part of the beam path; a lens arrangement arranged in the beam path down-beam of the aperture body; and a lens support arranged between the aperture body and the lens arrangement and configured to support the position of the lens arrangement relative to the aperture body; wherein the lens support comprises an electrical insulator; and the shield comprises a down-beam end, that is positioned between the aperture body and at least part of the lens arrangement, and the shield is configured to extend along the beam path up to the down-beam end.
Clause 41: The flood column according to clause 40, wherein the down-beam end of the shield is up beam of the lens arrangement.
Clause 42: The flood column according to clause 40 or 41, wherein the down-beam end of the shield is down-beam of the down-beam surface of the aperture body.
Clause 43: The flood column according to clause 40 to 42, further comprising a scanning deflector and, optionally, a ground plane arranged between the aperture body and the lens arrangement; and wherein the down-beam end of the shield extends to the scanning deflector, or optionally the ground plane.
Clause 44: The flood column according to clause 40 to 43, wherein the shield is comprised in a chamber wall of the flood column, and the chamber wall comprises an alloy capable of electromagnetic shielding.
Clause 45: the flood column of any of claims 37 to 41, wherein the anchor body is an aperture body arranged in the beam path and configured to blank and/or shape the charged particle flooding beam.
Clause 46: A flood column of any of claims 10 to 39 or 45, further comprising: a charged particle source configured to emit a charged particle beam along the beam path; a source lens arranged down-beam of the charged particle source; a condenser lens arranged down-beam of the source lens, wherein the aperture body is down beam of the condenser lens and is configured to pass a portion of the charged particle beam; and a controller configured to selectively operate the flood column in a high-density mode for charged particle flooding of a relatively small area of the sample, and a low-density mode for charged particle flooding of a relatively large area of the sample.
Clause 47: A charged particle assessment tool comprising: a stage configured to support a sample; a charged particle system for assessing the sample, wherein the charged particle system is configured to project a charged particle beam towards the sample and to detect charged particles emanating from the sample; and the flood column according to any proceeding clause configured to project a charged particle flooding beam towards the sample so as to flood the sample.
Clause 48: The charged particle assessment tool according to clause 47, wherein the flood column is configured to project a charged particle flooding beam to the sample to flood the sample prior to assessment of the sample by the charged particle system.
Clause 49: The charged particle assessment tool according to clause 47 or 48, wherein the charged particle system comprises a primary column for directing a primary charged particle beam onto the surface of the sample; and a detection column for detecting charged particles emitted from the surface of the sample due to the primary charged particle beam.
Clause 50: The charged particle assessment tool according to any of clauses 47 to 49, wherein the primary column comprises a primary charged particle source configured to emit a charged particle beam having a similar landing energy to the charged particle beam of the flood column.
Clause 51: The charged particle assessment tool according to any of clauses 47 to 50, further comprising a sample support configured to support the sample, the sample support configured to be set at the same voltage when the sample is configured to be in the beam path of the charged particle source of the flood column and when in the path of the beam path of the primary charged particle beam.
Clause 52: The charged particle assessment tool according to any of clauses 47 to 51, further comprising a moveable stage configured to move the sample support between a flooding position when the sample is in beam path of the charged particle beam of the flood column and an inspection position when the sample is in the beam path of the primary charged particle beam, preferably the flooding position and inspection position are spaced apart and/or preferably the beam path of the primary charged particle beam is spaced apart from the beam path of the charged particle beam of the flood column.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims. Reference to inspection throughout this specification is intended also to refer to measurement, i.e. metrological applications.

The descriptions above are intended to be illustrative, not limiting. Thus, it will be apparent to one skilled in the art that modifications may be made as described without departing from the scope of the claims set out below.

## Claims

1. A flood column for projecting a charged particle flooding beam along a beam path towards a sample to flood the sample with charged particles prior to assessment of the flooded sample using an assessment column, the flood column comprising:
an anchor body arranged along the beam path;
a lens arrangement arranged in a down-beam part of the flood column; and
a lens support arranged between the anchor body and the lens arrangement;
wherein the lens support is configured to position the lens arrangement and the anchor body relative to each other;
the lens support comprises an electrical insulator; and
the lens support is in the direct line of sight of at least a portion of the beam path in the down-beam part.

2. The flood column according to claim 1, wherein the lens arrangement comprises a final lens arrangement that is arranged adjacent to the sample.

3. The flood column according to claim 2, wherein the final lens arrangement is an electrostatic lens.

4. The flood column according to claim 2 or 3, wherein the lens arrangement further comprises an objective lens;
wherein, in the direction of beam path, the objective lens is separated from the final lens arrangement; and
the objective lens is arranged up-beam of the final lens arrangement.

5. The flood column according to claim 4, wherein the objective lens is configured to contribute to the deceleration of the flooding beam.

6. The flood column according to claim 4 or 5, wherein, in the direction of the beam path, the objective lens has a high aspect ratio.

7. The flood column according to any of claims 4 to 6, wherein part of the objective lens is configured to extend along the beam path in a direction away from the final lens arrangement so as to reduce the extent of the lens support that is in direct line of sight of at least a portion of the beam path.

8. The flood column according to any of claims 4 to 7, wherein the objective lens and final lens arrangement are secured to each other by at least part of the lens support.

9. The flood column of any preceding claim, wherein the anchor body comprises an aperture body arranged in the beam path and configured to blank and/or shape the charged particle flooding beam.

10. The flood column of claim 9, wherein the lens support is supported by the aperture body.

11. The flood column of claim 9 or 10, further comprising a scanning deflector arranged in the beam path between the aperture body and the lens arrangement.

12. The flood column according to claim 11, further comprising a ground plane in which is defined an aperture for the beam path of the flooding beam;
wherein the aperture of the ground plane is in the beam path between the scanning deflector and the lens arrangement.

13. The flood column according to any preceding claim, wherein there are a plurality of lens supports configured to position the lens arrangement and the aperture body; and
each lens support comprises an electrical insulator.

14. The flood column according to claim 13, wherein each of the lens supports has a radial surface portion most proximate to the beam path; and
the radial surface portions of the lens supports are equidistantly radially positioned from the beam path.

15. A charged particle assessment tool comprising:
a stage configured to support a sample;
a charged particle system for assessing the sample, wherein the charged particle system is configured to project a charged particle beam towards the sample and to detect charged particles emanating from the sample; and
the flood column according to any proceeding claim configured to project a charged particle flooding beam towards the sample so as to flood the sample.
